# EUROPEAN PATENT APPLICATION

(11) **EP 4 726 955 A1**
(43) Date of publication of application: **15.04.2026**
(21) Application number: 25194006.0
(22) Date of filing: 05.08.2025
(51) Int. Cl.: H02J 7/00, H02H 7/18, H01M 10/42

(54) **BATTERY APPARATUS AND BATTERY PACK**

(30) Priority: 11.10.2024 KR 20240138329
(71) Applicant: SAMSUNG SDI CO., LTD., Yongin-si, Gyeonggi-do 17084 (KR)
(72) Inventor: PARK, Jong Sam, 16678 Suwon-si, Gyeonggi-do (KR); YOO, Jae Shik, 16678 Suwon-si, Gyeonggi-do (KR)
(74) Representative: Gulde & Partner

(57) **Abstract**

The present disclosure relates to a battery apparatus and a battery pack that are made safer by detecting a battery charging situation through a discharge path (400) when the battery pack is in a shutdown state of the battery pack. To this end, the present disclosure provides a configuration for waking up a processor (100) using a voltage at both ends of a current detection element (500) when the processor (100) is in a sleep state and a battery is charged by a charging current supplied through a discharge path (400).

## Description

### CROSS-REFERENCE TO RELATED APPLICATION

The present application claims priority to and the benefit of Korean Patent Application No. 10-2024-0138329, filed on October 11, 2024, in the Korean Intellectual Property Office, the entire disclosure of which is incorporated herein by reference.

### BACKGROUND

### 1. Field

The present disclosure relates to a battery apparatus and a battery pack having a battery protection function.

### 2. Discussion of the Related Art

Secondary batteries are capable of being charged and recharged, unlike primary batteries that cannot be recharged. Low-capacity secondary batteries are used in small portable electronic devices such as smartphones, feature phones, notebook computers, digital cameras, and camcorders. Large-capacity secondary batteries are widely used as power sources for driving motors of hybrid vehicles, electric vehicles, and the like and as batteries for power storage. A secondary battery includes an electrode assembly including a positive electrode and a negative electrode, a case accommodating the electrode assembly, an electrode tab connected to the electrode assembly, and the like.

A charge path through which a charging current supplied to a battery pack flows and a discharge path through which a discharging current discharged from the battery pack flows may be divided according to a product group to which the battery pack including such a secondary battery is used. When the battery pack is in a shutdown state, a battery management system (BMS) is also in a shutdown state (or sleep state). Accordingly, the BMS cannot recognize that the battery pack is charged through the discharge path in the shutdown state of the battery pack, and a situation in which the battery is overcharged can occur. Overcharging a battery may cause problems, such as a fire in the battery pack.

The information disclosed in this Background section is for enhancement of understanding of the background of the present disclosure. The section therefore may contain information that does not constitute related (or prior) art.

### SUMMARY

The present disclosure is directed to providing a battery apparatus and a battery pack that are made safer by having a configuration such that when the battery pack and a battery management system (BMS) are in a shutdown state a charging situation of the battery pack through a discharge path is detected and a protection operation is performed according thereto.

However, objects that the present disclosure achieves are not limited to the above-described objects and other objects that are not described may be clearly understood by those skilled in the art from the following description.

In accordance with an aspect of the present disclosure, there is a provided a battery apparatus including a charge and discharge path through which a charging current can be supplied to a battery and a discharging current can be discharged from the battery, with a current detection element configured to detect a current being provided in the charge and discharge path, a discharge path that is branched off from the charge and discharge path and through which the discharging current can be discharged from the battery, and a wake-up element configured to wake up a processor based on a voltage at both ends of the current detection element when the battery is charged by the charging current supplied through the discharge path when the processor is in a sleep state.

In accordance with another aspect of the present disclosure, battery pack includes a charge terminal configured to receive a charging current for charging a battery; a discharge terminal, provided separate from the charge terminal and configured to output a discharging current from the battery; and a processor configured to wakes up in response to a wake-up signal that is generated when a charging current for charging the battery is input to the charge terminal or the discharge terminal and the battery pack is in a shutdown state.

### BRIEF DESCRIPTION OF THE DRAWINGS

The following drawings attached to this specification illustrate embodiments of the present disclosure, and describe aspects and features of the present disclosure together with the detailed description of the present disclosure. The present disclosure is not limited to the embodiments depicted in the drawings.
FIGS. 1 to 3 are views of a circuit structure of a battery management system (BMS) to which a battery apparatus according to an embodiment of the present disclosure is applied; and
FIG. 4 is a view of a circuit structure of a battery apparatus according to one embodiment of the present disclosure.

### DETAILED DESCRIPTION OF EXEMPLARY EMBODIMENTS

Hereinafter, embodiments of the present disclosure will be described, in detail, with reference to the accompanying drawings. The terms or words used in this specification and claims should not be construed as being limited to the usual or dictionary meaning and should be interpreted as being consistent with the technical idea of the present disclosure based on the principle that the inventor can be his/her own lexicographer to appropriately define the concept of the term to explain his/her invention in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc. may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure. Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc. may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed below could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Numerical ranges disclosed and/or recited herein include all sub-ranges of the same numerical precision subsumed within the recited ranges. For example, a range of "1.0 to 10.0" includes all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein includes all lower numerical limitations subsumed therein, and any minimum numerical limitation recited in this specification includes all higher numerical limitations subsumed therein. Accordingly, Applicant reserves the right to amend this specification, including the claims, to expressly recite any sub-range subsumed within the ranges expressly recited herein.

References to two compared elements, features, etc. as being "the same" may mean that they are "substantially the same." Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

When an arbitrary element is referred to as being disposed (or located or positioned) on the "above (or below)" or "on (or under)" a component, it may mean that the arbitrary element is placed in contact with the upper (or lower) surface of the component and may also mean that another component may be interposed between the component and any arbitrary element disposed (or located or positioned) on (or under) the component.

In addition, it will be understood that when an element is referred to as being "coupled," "linked" or "connected" to another element, the elements may be directly "coupled," "linked" or "connected" to each other, or an intervening element may be present therebetween, through which the element may be "coupled," "linked" or "connected" to another element. **In** addition, when a part is referred to as being "electrically coupled" to another part, the part can be directly connected to another part or an intervening part may be present therebetween such that the part and another part are indirectly connected to each other.

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

### 1. BMS circuit structure

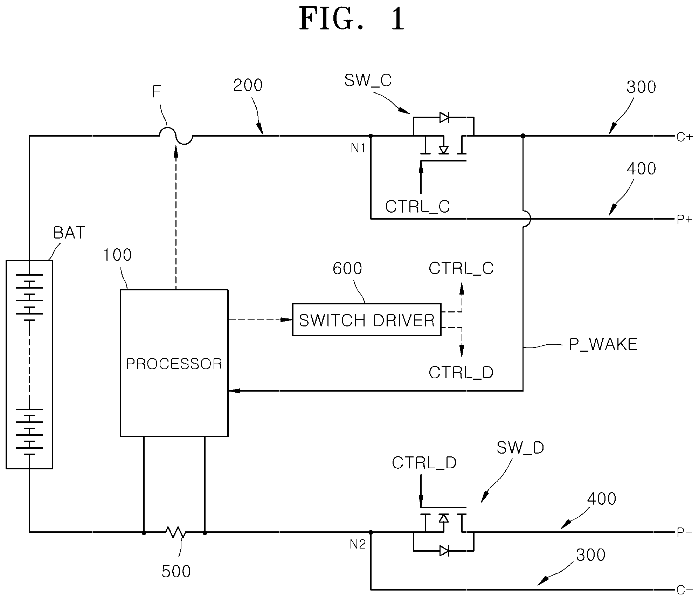

FIGS. 1 to 3 are views of a circuit structure for a battery management system (BMS) according to an embodiment of the present disclosure. To facilitate understanding of the present embodiment, the circuit structure of the BMS will be described first with reference to FIG. 1. A circuit of FIG. 1 may be used with the battery apparatus, which will be described below, and also corresponds to the circuit structure of the BMS partially constituting the present embodiment. For reference, a battery BAT may be a battery cell or battery module, and a voltage of the battery BAT monitored by a processor 100 may be a voltage of the battery cell or a voltage of the battery module.

The BMS illustrated in FIG. 1 may include the processor 100, a charge and discharge path 200, a charge path 300, a discharge path 400, a current detection element 500, and a switch driver 600. "Path" described in the present embodiment includes an element connected to a corresponding path, for a non-limiting example, a switch and a fuse. The BMS of FIG. 1 may be used with the battery pack with the battery.

The processor 100 may monitor a state of the battery and perform a control operation for the battery cell(s) based on the monitoring. For a non-limiting example, the processor 100 may be configured to monitor a voltage, a current, a temperature, and a state of charge (SOC) of the battery and perform a control operation such as balancing control, temperature control, or charge or discharge control. The processor 100 may also be configured to perform a protection operation such as switch control for preventing over-discharge or over-charge of the battery according to the result of the monitoring. The processor 100 may include an analog front end integrated circuit (AFE IC) and a micro controller unit (MCU) of the BMS. Although an example in which the AFE IC and the MCU of the BMS are integrated as one processor 100 is illustrated in FIG. 1, a configuration with two processors in which an AFE IC and an MCU are separated may be implemented according to an embodiment of the present disclosure.

The charge and discharge path 200 may serve as a path for supplying a charging current and discharging a discharging current for the battery. That is, the charging current is supplied to the battery through the charge and discharge path 200 when the battery is charged, and the discharging current is sent from the battery to a load through the charge and discharge path 200 when the battery is discharged. For the sake of clear distinction between terms, a path in which a first node N1, a protection element F, the battery, a current detection element 500, and a second node N2 are connected in FIG. 1 is defined as the charge and discharge path 200. In this case, the first and second nodes N1 and N2 are nodes to which the charge path 300 and the discharge path 400 are commonly connected.

The protection element F may be provided in the charge and discharge path 200 and implemented as a self-control protector (SCP) fuse for blocking a current flow in the charge and discharge path 200. The above-described processor 100 may block a current flow in the charge and discharge path 200 by operating (fusing) the protection element F. "Operating the protection element," which will be described below, is defined as "opening the path on which the protection element is provided" or "fusing a fuse" when an abnormality occurs in the battery pack, for a non-limiting example, a wire in the battery pack shorts due to excessive power consumption of the battery pack, and an overvoltage is generated in the battery cell.

The charge path 300 may be branched off from the above-described charge and discharge path 200 and may be a path through which a charging current flows to the battery cell for charging the battery cell. For the sake of clear distinction between terms, a path that connects a positive charge terminal C+ of an external charger (not shown) and the first node N1, and a path that connects a negative charge terminal C- of the external charger and the second node N2 in FIG. 1 are defined as the charge path 300.

As illustrated in FIG. 1, a charge control switch SW_C may be provided on the charge path 300. The charge control switch SW_C may be implemented as a field effect transistor (FET) for blocking a flow of a charging current in the charge path 300 by being turned on or off by control of the processor 100 and the switch driver 600. The processor 100 may block the flow of the charging current in the charge path 300 by controlling the charge control switch SW_C to be turned on or off using the switch driver 600.

A wake-up signal path P_WAKE branched off from a node of the positive charge terminal C+ on the charge path 300 (that is, a node between the positive charge terminal C+ and the charge control switch SW_C) and connected to the processor 100 may be provided in the BMS. The processor 100, which is in a sleep state when the battery pack is in a shutdown state, may be configured to wake up when a charge voltage signal is received through the wake-up signal path P_WAKE in a normal charge state in which the external charger is connected to a charge terminal, that is, the positive charge terminal C+ and the negative charge terminal C-. For the sake of distinction from the term "second wake-up signal," the charge voltage signal transmitted to the processor 100 through the wake-up signal path P_WAKE for waking up the processor 100 is defined as a "first wake-up signal."

The discharge path 400 may be branched off from the above-described charge and discharge path 200 and be a path through which a discharging current discharged from the battery flows. For the sake of clear distinction between terms, a path that connects a positive discharge terminal P+ (that is, a positive terminal of the battery pack) and the first node N1, and a path that connects a negative discharge terminal P- (that is, a negative terminal of the battery pack) and the second node N2 in FIG. 1 are defined as the discharge path 400.

As illustrated in FIG. 1, a discharge control switch SW_D may be provided on the discharge path 400. The discharge control switch SW_D may be implemented as an FET for blocking a flow of a discharging current in the discharge path 400 by being turned on or off by control of the processor 100 and the switch driver 600. The processor 100 may block the flow of the discharging current in the discharge path 400 by controlling the discharge control switch SW_D to be turned on or off using the switch driver 600.

The current detection element 500 may be implemented as a shunt resistor connected to the charge and discharge path 200 to detect an overcurrent flowing in the battery. The switch driver 600 may be a gate driver that controls the charge control switch SW_C and the discharge control switch SW_D to be turned on or off by applying control signals CTRL_C and CTRL_D to the charge control switch SW_C and the discharge control switch SW_D on the basis of control by the processor 100. Accordingly, the processor 100 may operate to prevent damage to the battery due to an overcurrent by detecting an overcurrent flows in the battery using the current detection element 500 and turning off the charge control switch SW_C or the discharge control switch SW_D by controlling the switch driver 600.

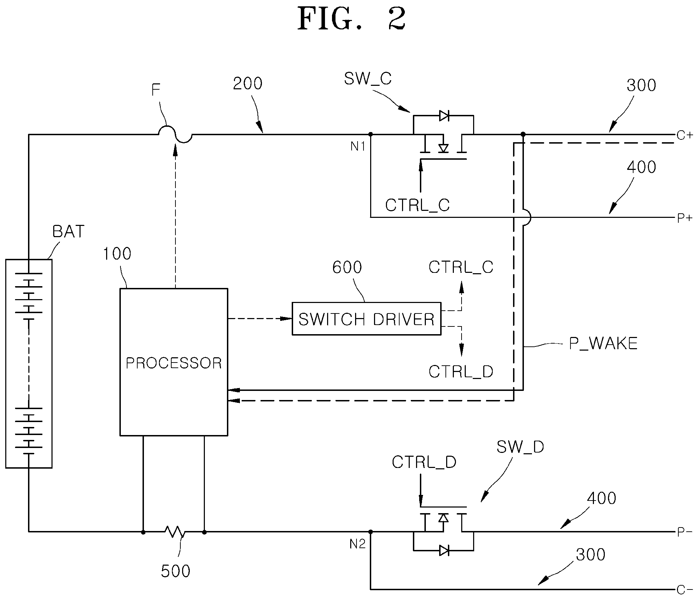

In a configuration where the charge path 300 and the discharge path 400 are independently provided as described above, as shown in FIG. 2, when the battery pack is in the shutdown state and the processor 100 is also in the sleep state and the external charger is connected to the charge terminals C+ and C- (that is, in a normal charge state in which the a charging current is input through the charge path 300), a voltage applied to the charge path 300 (or the charge terminals C+ and C-) is transmitted to the processor 100 through the wake-up signal path P_WAKE as the above-described first wake-up signal. The processor 100 may thereby wake up.

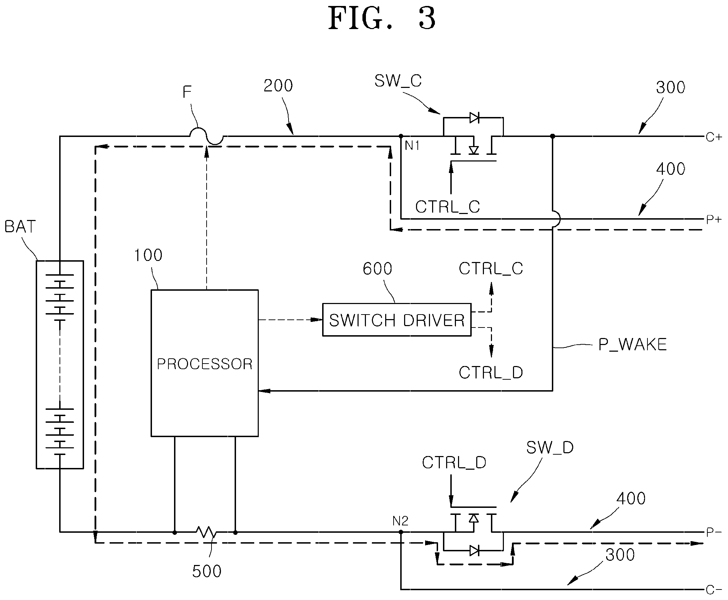

However, as shown in FIG. 3, when the battery pack is in the shutdown state and the processor 100 is also in the sleep state and the external charger is connected to the discharge terminals P+ and P- (that is, an abnormal charge state in which a charging current is input through the discharge path 400), since a signal for waking up the processor 100 may not be generated. Thus, a situation in which the processor 100 maintains the sleep state and the battery is continuously charged by the charging current input through the discharge path 400 occurs. Since the processor 100 is in the sleep state even if the battery is overcharged, a protection function for resolving the overcharging of the battery may not be performed. Thus, an accident such as a fire in the battery may occur.

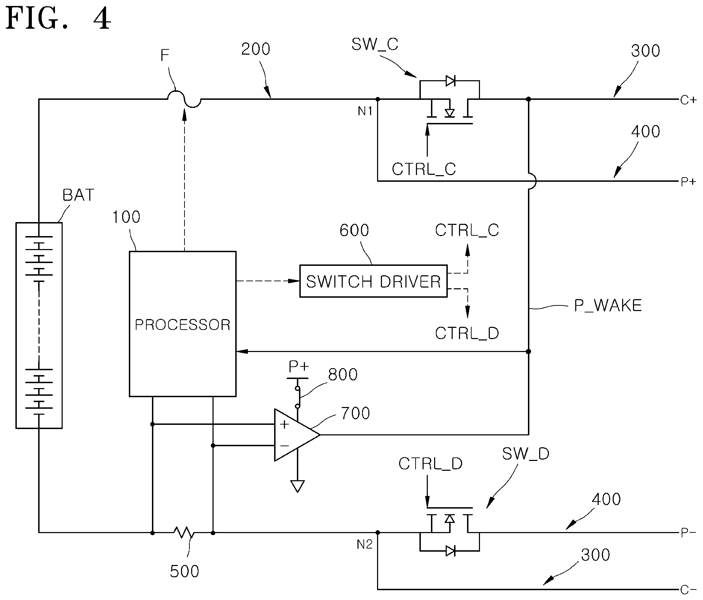

Accordingly, in the present embodiment a configuration such that the processor 100 is awoken when the battery is charged through the discharge path 400 in the shutdown state of the battery pack will be described with reference to FIG. 4.

### 2. Battery apparatus

FIG. 4 is a circuit diagram of a battery apparatus according to an embodiment of the present disclosure. The same reference numerals are assigned to the same components in FIGS. 1 to 4.

As illustrated in FIG. 4, a wake-up element 700 for waking up a processor 100 when the processor 100 is in a sleep state (e.g., when a battery pack is in a shutdown state) and a battery is charged by a charging current supplied through a discharge path 400 is provided in the present embodiment. A signal generated by the wake-up element 700 for waking up the processor 100 is defined as a second wake-up signal. An output node of the wake-up element 700 from which the second wake-up signal is output may be connected to the wake-up signal path P_WAKE.

When an external charger is connected to discharge terminals P+ and P-, a charging current input through the discharge terminals P+ and P- flows through a current detection element 500. Accordingly, a voltage determined according to a resistance value of the current detection element 500 and an amount of the charging current is applied to both ends of the current detection element 500. The wake-up element 700 may be configured to generate the second wake-up signal for waking up the processor 100 using the voltage applied to both ends of the current detection element 500.

The wake-up element 700 may be an amplifier such as an operational amplifier (OP-AMP) for receiving a voltage, which corresponds to a double-ended signal or differential signal, applied to both ends of the current detection element 500 to output a second wake-up signal corresponding to a single-ended signal. A gain of the amplifier may be determined based on the voltage applied to both ends of the current detection element 500 and a signal level for waking up the processor 100.

Accordingly, with the wake-up element 700, a circuit configuration may be provided that amplifies the voltage applied to both ends of the current detection element 500 according to the designed gain to output the second wake-up signal to wake up the processor 100 using the output second wake-up signal when the processor 100 is in the sleep state and the battery is charged by the charging current input through the discharge path 400. The woken-up processor 100 may determine whether the battery is overcharged by monitoring a voltage of the battery. A critical voltage of a battery cell or a critical voltage of a battery module for determining whether the battery cell or battery module is in an overcharged state may be defined in the processor 100. The processor 100 may thereby determine that the battery is in an overcharged state because the battery is charged by the charging current supplied through the discharge path 400 when a present voltage of the battery (or a present voltage of the battery cell or a present voltage of the battery module) is greater than or equal to the critical voltage. The processor 100 may then operate a protection element F (e.g., fuse a fuse), and block a current flow in a charge and discharge path 200. To prevent damage to a BMS caused by the charging of the battery through the discharge path 400, the processor 100 may, after waking up, block the current flow in the charge and discharge path 200 by immediately operating the protection element F after recognizing that the battery is being charged through the discharge path 400.

The above-described operation of the wake-up element 700 is performed before the processor 100 wakes up, that is, before the shutdown state of the battery pack is switched to an active state. Accordingly, operating power for operating the wake-up element 700 in the shutdown state of the battery pack is required. **In** the present embodiment, since the charger is connected to the discharge terminals P+ and P-, a configuration for using a voltage applied to one node of the discharge path 400 as an operating voltage of the wake-up element 700 is provided. The voltage applied to one node of the discharge path 400 corresponds to a charging voltage supplied by the charger connected to the discharge terminals P+ and P-. For convenience of description, the voltage applied to one node of the discharge path 400 and supplied to the wake-up element 700, that is, the charging voltage of the charger, is described as a discharge terminal voltage.

To selectively supply the discharge terminal voltage to the wake-up element 700 as the operating voltage according to whether the processor 100 is in the sleep state or wake-up state, a switch may be connected to one node of the discharge path 400 and a power input node of the wake-up element 700. The switch SW may be implemented as a normally closed (NC) type relay and configured to be controlled to be opened or closed by the processor 100.

As the switch SW is implemented as the NC type relay, when the processor 100 is in the sleep state, the switch SW maintains a closed state. Accordingly, a state in which the power input node of the wake-up element 700 and the discharge path 400 (or discharge terminals P+ and P-) are electrically connected is maintained. When the battery pack is in the shutdown state and the discharge terminals P+ and P- are not connected to the charger, since an operating voltage is not applied to the wake-up element 700, the wake-up element 700 is in an inactive state. When the battery pack is in the shutdown state and the discharge terminals P+ and P- are connected to the charger, the discharge terminal voltage is applied to the power input node of the wake-up element 700 through the switch SW, and the wake-up element 700 is thereby activated to generate the above-described second wake-up signal.

To preclude operation of the wake-up element 700 of the BMS after the processor 100 is woken up by the second wake-up signal, the processor 100 may deactivate the wake-up element 700 by opening the switch SW. Accordingly, operation of the wake-up element 700 is limited to a time period from when the discharge terminals P+ and P- are connected to the charger in the sleep state of the processor 100 to when the processor 100 wakes up. Thus, abnormal operation of the BMS caused by the operation of the wake-up element 700 connected to a signal path in the BMS may be prevented.

The operation of the battery apparatus will be briefly described below.

In a shutdown state of the battery pack and a sleep state of the processor 100, the processor 100 wakes up based on a wake-up signal generated when a terminal to which a charging current for charging the battery is input among the charge terminals C+ and C- and the discharge terminals P+ and P-.

When a charger is connected to the charge terminals C+ and C-, a first wake-up signal generated in a charge path 300 (charge terminals C+ and C-) is transmitted to the processor 100 through the wake-up signal path P_WAKE. The processor 100 is woken up by the first wake-up signal and turns on a charge control switch SW_C, and then the battery is charged by a charging current input through the charge path 300. **In** this case, the processor 100 may inactivate the wake-up element 700 by opening the switch SW. Thus, a situation in which the BMS operates abnormally caused by an operation of the wake-up element 700 connected to the signal path in the BMS is prevented. The processor 100 may be configured to be switched to a sleep state after closing the switch SW again when a wake-up state is switched to the sleep state.

When a charger is connected to the discharge terminals P+ and P- so that the battery is charged by a charging current input through the discharge path 400, a discharge terminal voltage is applied to the wake-up element 700 through the switch SW in the closed state so that the wake-up element 700 is activated. The wake-up element 700 receives a voltage at both ends of the current detection element 500 that is applied when the charging current flows in the current detection element 500 and outputs a second wake-up signal. The processor 100 is woken up by the second wake-up signal and performs a control operation and a protection operation for the battery. **In** this case, the processor 100 may inactivate the wake-up element 700 by opening the switch SW. Thus, a situation in which the BMS operates abnormally caused by an operation of the wake-up element 700 connected to the signal path in the BMS may be prevented. **In** addition, the woken-up processor 100 may block a current flow in the charge and discharge path 200 by immediately operating the protection element F after recognizing that the battery is being charged through the discharge path 400, or block a current flow in the charge and discharge path 200 by operating the protection element F when the battery is in an overcharged state due to being continuously charged.

According to the present disclosure, when the processor (the AFE IC or an MCU of the BMS) is in the sleep state and the battery is charged by a charging current supplied through the discharge path, the processor may be woken up by the wake-up element 700, which generates a wake-up signal using a voltage at both ends of the current detection element 500. The woken-up processor may block the battery from being charged through the discharge path by detecting an overcharged state of the battery and operating the protection element (e.g., fuse), thereby effectively preventing an accident of the battery pack caused by the battery pack being charged through the discharge path.

The embodiments described herein may be implemented, for example, as a method or process, a device, a software program, a data stream, or a signal. Although discussed in the context of a single type of implementation (for example, discussed only as a method), features discussed herein may also be implemented in other forms (for example, a device or a program). The device may be implemented by suitable hardware, software, firmware, and the like. The method may be implemented on a device, such as a processor, which generally refers to a processing device including a computer, a microprocessor, an integrated circuit, a programmable logic device, etc. The processor includes a communication device such as a computer, a cell phone, a personal digital assistant (PDA), and other devices that facilitate communication of information between the device and end-users.

Although the present disclosure has been described with reference to embodiments and drawings illustrating aspects thereof, the present disclosure is not limited thereto. Various modifications and variations can be made by a person skilled in the art to which the present disclosure belongs within the scope of the technical spirit of the present disclosure.

## Claims

1. A battery apparatus comprising:
a charge and discharge path (200) through which a charging current can be supplied to a battery and a discharging current can be discharged from the battery, with a current detection element (500) configured to detect a current being provided in the charge and discharge path (200);
a discharge path (400) that is branched off from the charge and discharge path (200) and through which the discharging current can be discharged from the battery; and
a wake-up element (700) configured to wake up a processor (100) based on a voltage at both ends of the current detection element (500) when the battery is charged by the charging current supplied through the discharge path (400) when the processor (100) is in a sleep state.

2. The battery apparatus of claim 1, further comprising:
a charge path (300) that is branched off from the charge and discharge path (200) and through which the charging current can be supplied to the battery; and
a wake-up signal path (P_WAKE) which is formed with a structure branched off from the charge path (300) and serves as a path through which a voltage applied at the charge path (300) is transmitted to the processor (100) as a wake-up signal for waking up the processor (100),
wherein an output node of the wake-up element (700) is connected to the wake-up signal path (P_WAKE).

3. The battery apparatus of claim 2, wherein the wake-up signal is a first wake-up signal,
wherein the processor (100) is configured to be (i) woken up by the first wake-up signal transmitted through the wake-up signal path (P_WAKE) when the processor (100) is in the sleep state and the charging current is supplied through the charge path (300) and (ii)woken up by a second wake-up signal output from the wake-up element (700) when the processor (100) is in a sleep state and the charging current is supplied through the discharge path (400).

4. The battery apparatus of claim 2 or 3, further comprising a switch disposed between and connected to a node on the discharge path (400) and a power input node of the wake-up element (700).

5. The battery apparatus of claim 4, wherein the wake-up element (700) is configured to be operated by an operating voltage that is input from the node of the discharge path (400) and through the switch in the sleep state of the processor (100).

6. The battery apparatus of claim 5, wherein the processor (100) is configured to determine whether the battery is overcharged by monitoring a voltage of the battery after the processor (100) is woken up by the wake-up element (700).

7. The battery apparatus of claim 6, further comprising a protection element (F) provided in the charge and discharge path (200) and configured to block a current in the charge and discharge path (200),
wherein the processor (100) is configured to block the current in the charge and discharge path (200) by operating the protection element (F) when the processor (100) determines that the battery is overcharged.

8. The battery apparatus of claims 5 to 7, wherein the switch is implemented as a normally closed, NC,-type switch, and
wherein the processor (100) is configured to deactivate the wake-up element (700) by opening the switch after being woken up by the first wake-up signal or the second wake-up signal.

9. The battery apparatus of claim 8, wherein the processor (100) is configured to be switched to a sleep state after closing the switch when switched to the sleep state from a wake-up state.

10. The battery apparatus of claims 1 to 9, wherein the wake-up element (700) includes an amplifier that receives a double-ended signal as the voltage at both ends of the current detection element (500) and outputs a single-ended signal as a second wake-up signal for waking up the processor (100).

11. The battery apparatus of claim 10, wherein the amplifier of the wake-up element (700) is an operational amplifier (OP-AMP) for receiving a voltage, which corresponds to a double-ended signal or differential signal, applied to both ends of the current detection element (500) to output a second wake-up signal corresponding to a single-ended signal.

12. A battery pack comprising:
a charge terminal configured to receive a charging current for charging a battery;
a discharge terminal, provided separate from the charge terminal and configured to output a discharging current from the battery; and
a processor (100) configured to wakes up in response to a wake-up signal that is generated when a charging current for charging the battery is input to the charge terminal or the discharge terminal and the battery pack is in a shutdown state.

13. The battery pack of claim 12, wherein the wake-up signal is generated on the basis of a voltage applied to the charge terminal or the discharge terminal when the charging current for charging the battery is input to the charge terminal or the discharge terminal.

14. The battery pack of claim 13, further comprising a charge and discharge path (200) through which the charging current can be supplied to the battery and the discharging current can be discharged from the battery, with a current detection element (500) configured to detect a current being provided in the charge and discharge path (200),
wherein the wake-up signal is generated based on a voltage at both ends of the current detection element (500) when the charging current for charging the battery is input to the discharge terminal.

15. The battery pack of claim 13, further comprising a wake-up element (700) configured to wake up the processor (100) by generating the wake-up signal based on the voltage at both ends of the current detection element (500) and send the wake-up signal to the processor (100) when the charging current for charging the battery is input to the discharge terminal and/or
wherein the charge terminal and an output terminal of the wake-up element (700) are connected to a node.
